(19) Europäisches Patentamt
European Patent Office
Office européen des brevets

(11) EP 3 138 191 B1

(12) EUROPEAN PATENT SPECIFICATION

(45) Date of publication and mention
of the grant of the patent:
**18.12.2019 Bulletin 2019/51**

(51) Int Cl.:
**H02M 5/458** *(2006.01)*      **G01R 31/42** *(2006.01)*
**G01R 31/02** *(2006.01)*

(21) Application number: **15723426.1**

(22) Date of filing: **16.04.2015**

(86) International application number:
**PCT/EP2015/000814**

(87) International publication number:
**WO 2015/165574 (05.11.2015 Gazette 2015/44)**

(54) **A METHOD FOR MONITORING DC LINK CAPACITANCE IN A POWER CONVERTERS**

**VERFAHREN ZUR ÜBERWACHUNG EINER GLEICHSTROMVERBINDUNGSKAPAZITÄT IN LEISTUNGSWANDLERN**

**PROCÉDÉ DE SURVEILLANCE DE LA CAPACITÉ DE LIAISON CC DANS DES CONVERTISSEURS DE PUISSANCE**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.04.2014 EP 14460024**

(43) Date of publication of application:
**08.03.2017 Bulletin 2017/10**

(73) Proprietor: **ABB Schweiz AG**
**5400 Baden (CH)**

(72) Inventors:
• **LIPNICKI, Piotr**
  **PL-20-861 Lublin (PL)**
• **LEWANDOWSKI, Daniel**
  **PL-30-384 Krakow (PL)**

(74) Representative: **Wroblewski, Marcin Jan**
**Jvwf Rzecznicy Patentowi Marcin Wroblewscy**
**Swierkowa 18**
**95-083 Florentynow (PL)**

(56) References cited:
**EP-A2- 0 652 445      US-A1- 2009 072 839**
**US-A1- 2010 295 554      US-A1- 2013 155 729**

Remarks:
The file contains technical information submitted after the application was filed and not included in this specification

**Description**

The subject of the invention is a method for monitoring DC link capacitance in power converters which is useful in condition monitoring of electronic equipment.

BACKGROUND OF THE INVENTION

Many of converters applications are being considered as critical for plant production process. Offering enhanced functionality in modern power converters is a way to gain a competitive advantage in worldwide market. One of the values to the customers comes from low cost condition monitoring of critical equipment and from optimized maintenance costs. DC link is one of the elements of power converters circuits. Although the designers pay a lot of attention when designing DC link, breakdowns and failures of the DC link can still happen. Unfortunately this means that the whole converter must be shutdown in emergency mode to be repaired. Nowadays, monitoring of the DC link is becoming one of the desired features from customer side, as well as from the converter manufacturer.

The ever-increasing demands for greater efficiency and reliability of power converters, force the introduction of novel methods for improving their performance. One of the ways is to provide a detailed condition monitoring features for the elements of the converter, ensuring tracking of entire device status. Assuring proper monitoring of the DC link capacitance level is one of the solutions for converter status determination. The capacitor deterioration usually manifests by an increase in ESR and decrease in an effective capacitance. Earlier detection of the ESR increase allows for preventive mitigation actions - i.e. scheduling shutdown and repairs. Moreover it also helps with evaluation of the expected operational time until failure may happen. Preventing the growth of ESR values over a specified level provides maintaining the quality of converted power and protects the converter from DC-link failure.

There is known from patent US 2010/0295554 A1 a method and system for monitoring the condition of the capacitor arrangement of the DC-voltage intermediate circuit of a power electronics appliance, such as of a frequency converter, at the place of usage, in which method the discharge voltage over the capacitor arrangement as a function of time is measured, and in which method the intermediate circuit is pre-charged With a pre-determined DC voltage, the pre-charging is removed from the intermediate circuit, the voltage of the intermediate circuit is measured by sampling at regular intervals, the voltage drop as a function of time is determined on the basis of the measured voltage of the intermediate circuit, the capacitance or the relative change in it is determined on the basis of the voltage drop, the value of the determined capacitance or of the relative change in it is compared to a pre-determined limit value on the basis of the voltage drop, and the necessary condition monitoring procedure is performed when the value determined with the measurement reaches the pre-determined limit value or is close to it. The disadvantage of the method is the need for performing initial measurement of the discharge curve and performing the measurements each time before starting the converter, thus it cannot be used online continuously.

There is known from patent US6381158B1 a system and method for monitoring DC link capacitance in three level inverters where a signal is injected into a neutral point regulator of an inverter drive and the response to that injected signal is monitored as an indication of the capacitance of the inverter drive. The disadvantage of the method is the need of additional passive elements used for additional device which is responsible for signal injecting.

From patent application US2009/0072839 there is known an apparatus and method to detect failure of smoothing electrolytic capacitor.

According to solution presented in patent application US2009/0072839 the designed controller detects failure of the smoothing electrolytic capacitor when the motor is not in the operation or before motor is activated.

From EP patent application EP0652445 an apparatus for inspecting electric components for inverter circuit is known. The apparatus has a DC power supply for supplying a direct current to a given position in an inverter circuit; a voltage detector for detecting a voltage at a given position in the inverter circuit; a current detector for detecting a current flowing at a given position in the inverter circuit; a switching circuit for changing positions at which the direct current is supplied from the DC power supply, positions at which the voltage is detected by the voltage detector, and positions at which the current is detected by the current detector; and a controller for outputting a switching signal to the switching circuit. The switching circuit is controlled by the controller to charge an electrolytic capacitor in an inverter circuit with a current from the DC power supply. The electrolytic capacitor is determined as to its quality by determining whether the calculated electrolytic capacitance of the electrolytic capacitor falls within a preset range or not. Each of transistors of the inverter circuit is determined as to its quality by determining whether a VCE - IC curve thereof falls in a preset range or not. The electrolytic capacitor, the transistors, and also diodes connected across the transistors can be determined as to whether they acceptable or not while they are being connected in the inverter circuit.

From US patent application US2013/0155729 a system and method for detecting phase loss and diagnostic DC link capacitor health in adjustable speed drive is known. A system ASD includes an input unit to detect operating data from the ASD. The operating data includes a DC link current of the ASD. The system also includes a state observer that is adapted to receive the operating data from the input unit and extract a DC link capacitor current of the ASD using the DC link current. The system also includes a controller programmed to compare the extracted DC link capacitor current to a predetermined fault range and generate a fault indication of an input phase loss if the extracted DC link capacitor current is within the predefined fault range. The controller is also programmed to calculate an estimated lifespan of the DC link capacitor based on the extracted DC link capacitor current.

**SUMMARY OF THE INVENTION**

The presented invention provides a diagnostic method for monitoring DC link in power converters according to claim 1 and a system for monitoring the DC link capacitance according to claim 2.

The presented invention is advantageous relative to the previously described existing methods as it allows for monitoring of the DC link using less measurement devices inside the power converter, namely only DC link voltage measuring device is used. Moreover in the method according to the invention the calculation process is simplified and thus does not required a significant calculation power. Also by using synchronization with inverter switching signal further simplification in software by reducing algorithm complexity and in hardware by reducing number of elements is achieved, so the inventive method allows for saving time during monitoring DC link capacitance.

BRIEF DESCRIPTION OF THE DRAWINGS

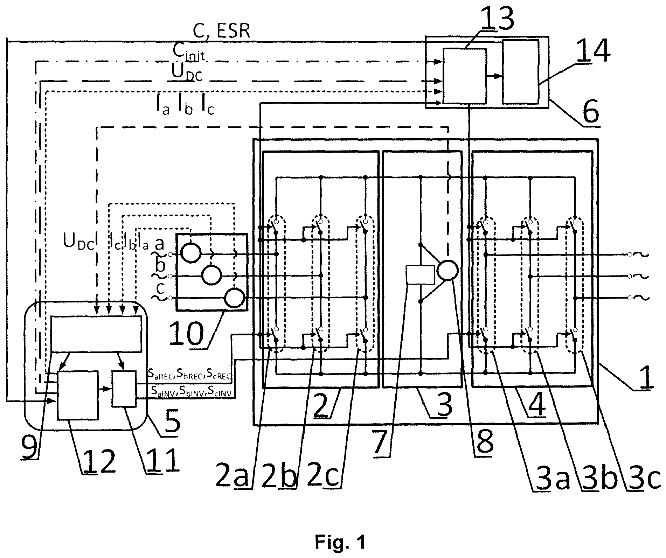

Fig.1 - is a picture of power converter equivalent system,

Fig.2 - is a diagram of operations performed for method for monitoring DC link in accordance with the invention,

Fig.3 - is an electrical scheme of basic DC link circuit,

Fig. 4 - is a plot of measured parameters during time period for indicating consecutive triggering signals $S_{TRIG}$,

Fig. 5 - is a plot of measured current during time period for presenting the DC-link current reconstruction principle.

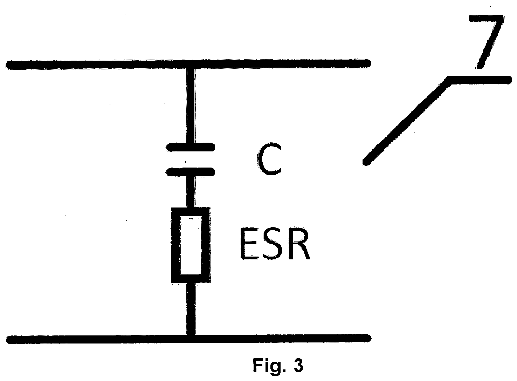

A power converter system comprises a power converter circuit 1 having a rectifying unit 2, a DC link unit 3, an inverter unit 4, and the power converter circuit 1 is connected with a converter control unit 5 and a DC link monitoring unit 6. The converter control unit 5 and the DC link monitoring unit 6 may be combined in single unit what is not presented in the drawing. The power converter circuit 1, the control unit 5 and DC link monitoring unit 6 are powered by three phase power supply lines a, b, c. The rectifying unit 2 has at least two solid state switches 2a, 2b, 2c, forming an inverter switching leg for each phase a, b, c, for converting the AC input voltage into DC output voltage. The solid state switches of the rectifying unit 2 is one of the possible known kinds - e.g. diodes, transistors, thyristors, etc. The DC link unit 3 includes at least one DC link circuit 7 and a DC link voltage measuring device 8. DC link circuit 7 comprises capacitor and an equivalent of series resistance ESR presented in figure 3. The inverter unit 4 has at least two solid state switches 3a, 3b, 3c, forming an rectify switching leg for each phase a, b, c, for converting the DC input voltage into AC output voltage. The solid state switches of the inverting unit 4 can be one of the possible known kinds - e.g. transistors, thyristors etc. The converter control unit 5 is a computer device, having a data acquisition module 9 for receiving and processing input signals such as: current $I_a$, $I_b$, $I_c$, measured by the sensors 10 mounted on power supply lines a, b, c, and a voltage $U_{DC}$ of DC link unit 3, connected to the circuit 7. The converter control unit 5 is also equipped with an output module 11 for generating switching signals for solid switches 2a, 2b, 2c of the rectifying unit 2 and for solid switches 3a, 3b, 3c of the inverter unit 4. The converter control unit 5 is also equipped with an alarm generating module 12, for comparing the initial capacitance $C_{int}$ and total capacitance C, and for generating alarm if certain condition is met. The DC link monitoring unit 6 is a computer device, having processing unit 13 for receiving and processing input signals such as: current $I_a$, $I_b$, $I_c$ and a voltage $U_{DC}$ of DC link unit 3, and signals from switches 2a, 2b, 2c, 3a, 3b, 3c. The DC link monitoring unit 6 is equipped with the calculation module 14 for calculating an indicator of ESR (Equivalent Series Resistance) and for calculation a total capacitance C of the DC link unit 3.

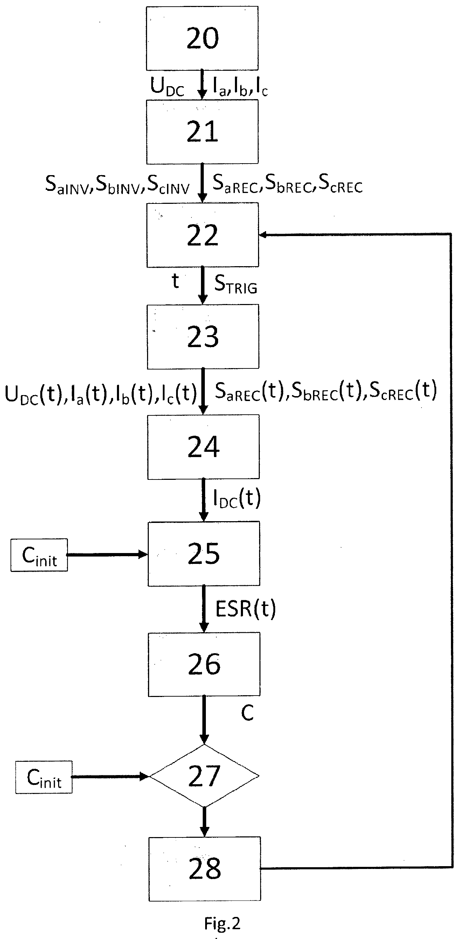

The inventive method is implemented according to the following steps 20-28 presented in fig.2.

Step 20

Checking if there is Cinit value provided by the user.

Measuring a DC link voltage Uoc by the DC link voltage measuring device 8 and measuring current $I_a$, $I_b$, $I_c$ of three phase power supply lines a, b, c , by the sensors 10.

Step 21

Calculation inverter switching signals $S_{aINV}$, $S_{bINV}$, $S_{cINV}$ of the inverter unit 3 and rectifier switching signals $S_{aREC}$, $S_{bREC}$, $S_{cREC}$ of the rectifier unit 2 in the converter control unit 5, using known control methods for such calculation e.g. field oriented control method, scalar control method, direct torque control method, and sending calculated data to the rectifier unit 2, the inverter unit 3 and DC link monitoring unit 6. The calculation is realized in the converter control unit 5. The switching signals can take the following values, according to the formulae's:

$$S_{aREC} = \begin{cases} 1, \\ 0 \end{cases} ; \ S_{bREC} = \begin{cases} 1, \\ 0 \end{cases} ; \ S_{cREC} = \begin{cases} 1, \\ 0 \end{cases}$$
$$S_{aINV} = \begin{cases} 1, \\ 0 \end{cases} ; \ S_{bINV} = \begin{cases} 1, \\ 0 \end{cases} ; \ S_{cINV} = \begin{cases} 1, \\ 0 \end{cases}$$

$$(1)$$

Step 22

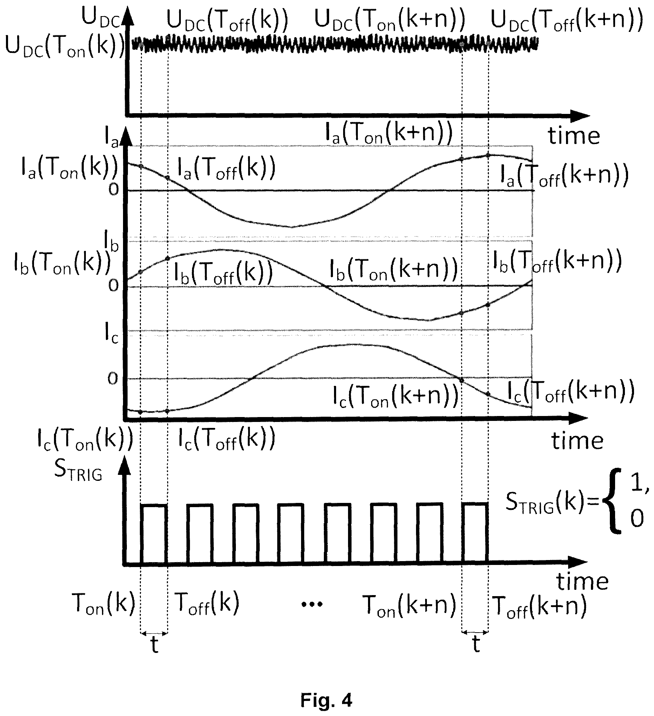

Generating a trigger signal $S_{TRIG}$ by comparison each individual switching signal with all remaining switching signals and when $S_{aINV}==S_{bINV}==S_{cINV}$ then the trigger signal $S_{TRIG}$ has a value equal to 1.
Determination of triggered time duration t for the trigger signal $S_{TRIG}$ and indicate measured current $I_a$, $I_b$, $I_c$ in the time t as $I_a(t)$, $I_b(t)$,$I_c(t)$, where triggered time duration t is defined as the time between start $T_{on}$ and stop $T_{off}$ of the trigger signal $S_{TRIG}$, where k - n are consecutive number of triggered time duration t, what is presented in the fig. 4 and described according to the formulae:

$$T_{on}(k) < t < T_{off}(k) \cdots T_{on}(k + n) < t < T_{off}(k + n)$$

$$(2)$$

Step 23

Determination switching signals $S_{aREC}$, $S_{bREC}$, $S_{cREC}$ of the rectifying unit 2 from the converter control unit 5 at the triggered time t as $S_{aREC}(t)$, $S_{bREC}(t)$, $S_{cREC}(t)$ and determination of the DC link voltage $U_{dc}$ and current $I_a$, $I_b$, $I_c$ of three phase power supply lines a, b, c at the triggered time t as $U_{dc}(t)$, $I_a(t)$, $I_b(t)$, $I_c(t)$.

Step 24

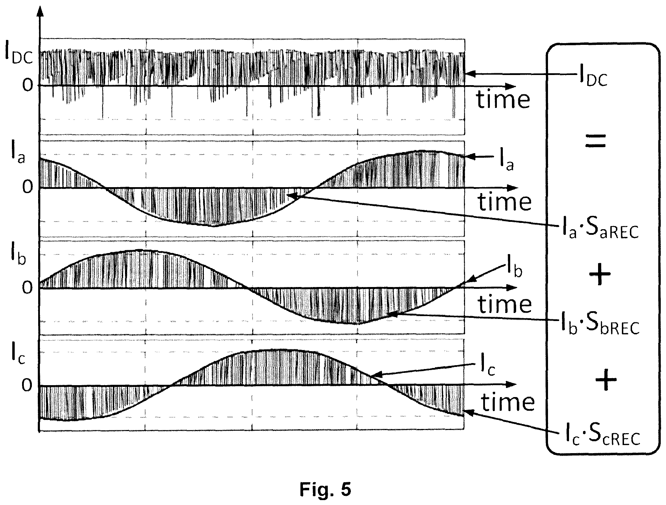

Reconstructing the DC link current by multiplying phase current $Ia(t)$, $I_b(t)$, $I_c(t)$ at the triggered time t by corresponding rectify switching signal $S_{aREC}(t)$, $S_{bREC}(t)$, $S_{cREC}(t)$ at the triggered time t and making a sum of all results what is presented in fig. 5 and described according to the formulae:

$$I_{DC}(t) = S_{aREC}(t) \cdot I_a(t) + S_{bREC}(t) \cdot I_b(t) + S_{cREC}(t) \cdot I_c(t)$$

$$(3)$$

where:

$I_a(t)$ - is a measured current for phase a, at the triggered time t,
$I_b(t)$, - is a measured current for phase b, at the triggered time t,
$I_c(t)$, - is a measured current for phase c, at the triggered time t,
$S_{aREC}(t)$, - is a value of switching signal of the rectifying unit for phase a, at the triggered time t,
$S_{bREC}(t)$, - is a value of switching signal of the rectifying unit for phase b, at the triggered time t,
$S_{cREC}(t)$, - is a value of switching signal of the rectifying unit for phase c, at the triggered time t.

Step 25

Calculating an indicator of an Equivalent Series Resistance (ESR) in monitoring unit 6, which requires the DC link voltage Uoc measured voltage and $I_{DC}$ current obtained using equation 3 and is initial DC link capacitance provided by the user, according to the formula:

$$ESR(t) = \int_{T_{on}}^{T_{off}} \frac{\frac{dU_{DC}(t)}{dt} - \frac{I_{DC}(t)}{C_{init}}}{\frac{dI_{DC}(t)}{dt}} \, dt \qquad (4)$$

where:

$U_{DC}(t)$- is measured DC link voltage at the triggered time t,
$C_{init}$ - is initial DC link capacitance stored in the converter control unit 5,
$I_{DC}(t)$ - is calculated DC link current, at the triggered time t,
$T_{on}$ - is the start time of the triggered signal $S_{TRIG}$,
$T_{off}$ - is the stop time of the triggered signal $S_{TRIG}$.

Step 26

Calculating the total DC link capacitance C (in percent's), which requires using $I_{DC}$ current obtained using equation 3, ESR indicator obtained using equation 4 and measured DC link voltage, according to the formulae:

$$C\,[\%] = \frac{(I_{DC}(t) \cdot ESR(t) - U_{DC}(t))^2}{U_{DC}^2(t)} \cdot 100\% \qquad (5)$$

where:

$I_{DC}(t)$ - is calculated reconstructed DC link current,

$U_{DC}(t)$ - is measured DC link voltage,

$ESR(t)$ - is calculated equivalent series resistance.

Step 27

Comparing the initial capacitance $C_{init}$ with the calculated total capacitance C in alarm generating module 12, according to the formulae:

$$C\,[\%] < k_p \cdot C_{init}[\%] \qquad (6)$$

Where the value of $k_p$ is a threshold value given by user depended on a nominal power of the converter, for example for the converter of 1MW power the value of $k_p$ is preferably 0.7.

Step 28

Generating an alarm if the threshold value multiplied by the initial capacitance $C_{init}$ is exceeded and sending a command from alarm generating module 12 to the output module 11 where rectify switching signals $S_{aREC}$, $S_{bREC}$, $S_{cREC}$ of rectifying unit 2 and inverter switching signals $S_{aINV}$, $S_{bINV}$, $S_{cINV}$ of inverter unit 4, are set to 0, which signals automatically switched off the converter circuit 1. In all other situations steps 22- 27 are repeated.

**Claims**

1.   A method for monitoring DC link capacitance in power converters comprising a rectifying unit (2) receiving power from three phase power supply lines (a,b,c), a DC link unit (3) and an inverter unit (4), wherein said method comprises the following steps:

- measuring the currents (Ia,Ib,Ic) of the three phase power supply lines (a,b,c),
- measuring voltage of the DC link unit 3 and setting initial capacitance $C_{int}$ of the DC link, where the initial capacitance of the DC link is given by the user,
- determining inverter switch states of the inverter and rectifier switch states of the rectifier for each phase a, b, c, where the switching states have a value equal to 0 or 1,
- generating a trigger signal $S_{TRIG}$ when the value of the inverter switch states of the inverter for each phase a, b, c have an equal value and determining a triggered time duration t for the generated trigger signal,
- determining the rectifier switch states of the rectifier unit 2 for each phase a, b, c at the triggered time duration t and measuring the currents (Ia,Ib,Ic) of the three phase power supply lines a,b,c at the triggered time and measuring the voltage of the DC link at the triggered time duration t,
- reconstructing the DC link current $I_{DC}(t)$ at the triggered time duration t using the following formulae:

$$I_{DC}(t) = S_{aREC}(t) \cdot I_a(t) + S_{bREC}(t) \cdot I_b(t) + S_{cREC}(t) \cdot I_c(t)$$

- where:

  - $I_a(t)$ - is a measured current for phase a at the triggered time duration t,
  - $I_b(t)$ - is a measured current for phase b at the triggered time duration t
  - $I_c(t)$ - is a measured current for phase c at the triggered time duration t,
  - $S_{aREC}(t)$ - is a value of switching signal of the rectifying unit for phase a at the triggered time duration t,
  - $S_{bREC}(t)$ - is a value of switching signal of the rectifying unit for phase b at the triggered time duration t,
  - $S_{cREC}(t)$ - is a value of switching signal of the rectifying unit for phase c at the triggered time duration t,

- calculating an indicator ESR (Equivalent Series Resistance) for the DC link voltage at the triggered time duration t according to the formulae:

$$ESR(t) = \int_{T_{on}}^{T_{off}} \frac{\frac{dU_{DC}(t)}{dt} - \frac{I_{DC}(t)}{C_{init}}}{\frac{dI_{DC}(t)}{dt}} dt$$

where:

  $U_{DC}(t)$ - is a measured DC link voltage at the triggered time duration t,
  $C_{init}$ - is initial DC link capacitance given by the user and stored in the converter control unit,
  $I_{DC}(t)$ - is a reconstructed current of the DC link at the triggered time duration t,
  $T_{on}$ - is the start time of the triggered signal $S_{TRIG}$,
  $T_{off}$ - is the stop time of the triggered signal $S_{TRIG}$,

- calculating a total DC link capacitance C according to the formulae:

$$C\ [\%] = \frac{(I_{DC}(t) \cdot ESR(t) - U_{DC}(t))^2}{U_{DC}^2(t)} \cdot 100\%$$

where:

  $I_{DC}(t)$ - is calculated DC link current at the triggered time duration t,
  $U_{DC}(t)$ - is measured DC link voltage at the triggered time duration t,

6

ESR(t) is the calculated equivalent series resistance indicator at the trigerred time duration t, and
- comparing the value of total DC link capacitance C with the initial DC link capacitance $C_{int}$ is performed and triggering an alarm when the total DC link capacitance C is bigger than the initial DC link capacitance $C_{int}$ multiplied by a threshold value given by the user.

2. A system for monitoring DC link capacitance in power converter comprising a power converter circuit (1) with a rectifying unit (2) receiving power from three phase power supply lines (a,b,c), a DC link unit (3); an inverter unit (4) which are connected with a converter control unit (5) and with a DC monitoring unit (6) and with means for measuring electrical parameters of the system, further having means for setting initial capacitance $C_{int}$ of the DC link, where the initial capacitance of the DC link is given by the user in a computer device; means for determining inverter switch states of the inverter unit (4) for one phase; means for comparing the value of inverter switch states and for generating a trigger signal $S_{TRIG}$; means for determining a triggered time duration t; means for reconstructing the DC link current at the triggered time duration t;
**characterized in that it further comprises:**

- means for determining inverter switch states of the inverter unit (4) and means for determining rectifier switch states of the rectifier unit (2) for each phase a, b, c, implemented in the computer device,
- means for comparing the value of inverter switch states and for generating a trigger signal $S_{TRIG}$ when the value of the inverter switch states of the inverter unit (4) for each phase a, b, c have an equal values, implemented in the converter control unit (5), where means for determining the triggered time duration t are implemented,
- means for determining the rectifier switch states of the rectifier unit (2) for each phase a, b, c at the triggered time duration t and means for measuring the three phase currents (Ia,Ib,Ic) of the three phase power supply lines (a, b,c) at the triggered time duration t, and means for measuring the voltage of the DC link unit (3) at the triggered time duration t,
- means for calculating a total DC link capacitance C and an indicator ERS (Equivalent Series Resistance) for the DC link unit (3) voltage at the triggered time duration t, and a reconstructed DC link current ($I_{DC}(t)$) at the triggered time duration t, where the total DC link capacitance C is calculated according to the formulae:

$$C\ [\%] = \frac{(I_{DC}(t) \cdot ESR(t) - U_{DC}(t))^2}{U_{DC}^2(t)} \cdot 100\%$$

where:

$I_{DC}(t)$ - is a DC link current at the triggered time duration t,
$U_{DC}(t)$ - is measured DC link voltage at the triggered time duration t,
ESR(t) - is an indicator ESR (Equivalent Series Resistance) for the DC link voltage calculated at the triggered time duration t, and the indicator ESR is calculated according to the formulae:

$$ESR(t) = \int_{T_{on}}^{T_{off}} \frac{\dfrac{dU_{DC}(t)}{dt} - \dfrac{I_{DC}(t)}{C_{init}}}{\dfrac{dI_{DC}(t)}{dt}} dt$$

where:

$U_{DC}(t)$ - is a measured DC link voltage at the triggered time duration t,
$C_{init}$ - is initial DC link capacitance given by the user and stored in the converter control unit,
$I_{DC}(t)$ - is a reconstructed current od DC link at the triggered time duration t,
$T_{on}$ - is the start time of the triggered signal $S_{TRIG}$,
$T_{off}$ - is the stop time of the triggered signal $S_{TRIG}$,

where the reconstructed DC link current is calculated according to the formulae :

$$I_{DC}(t) = S_{aREC}(t) * I_a(t) + S_{bREC}(t) * I_b(t) + S_{cREC}(t) * I_c(t)$$

where :

$I_a(t)$ is a measured current for phase a at the triggered time duration t,
$I_b(t)$ is a measured current for phase b at the triggered time duration t,
$I_c(t)$ is a measured current for phase c at the triggered time duration t,
$S_{aREC}(t)$ is a value of switching signal of the rectifying unit for phase a at the triggered time duration t,
$S_{bREC}(t)$ is a value of switching signal of the rectifying unit for phase b at the triggered time duration t,
$S_{cREC}(t)$ is a value of switching signal of the rectifying unit for phase c at the triggered time duration t,

- means for comparing the value of total DC link unit (3) capacitance C with the initial DC link capacitance $C_{int}$,
- means for triggering an alarm when the total DC link capacitance C is bigger than the initial DC link capacitance $C_{int}$ multiplied by a threshold value given by user.

3. A system according to claim 2, characterized that the converter circuit 1 comprises solid switches (2a,2b,2c) and (3a,3b,3c) connected to the switching legs of the rectifying unit (2) and inverter unit 4 respectively.

4. A system according to claim 3, **characterized in that** the solid switches (2a,2b,2c) and (3a,3b,3c) have a form of diodes or transistors or thyristors.

5. A computer program for monitoring DC link capacitance in power converter system, which computer program is loadable in and executable on a data processing unit (13) of a computer device having a form of a DC monitoring device (6) and which computer program comprises instructions to cause the system of claim 2 to execute the steps of the method according to claim 1.

**Patentansprüche**

1. Ein Verfahren zum Überwachen der Zwischenkreiskapazität in Leistungswandlern, umfassend eine Gleichrichtereinheit (2), die Leistung von dreiphasigen Stromversorgungsleitungen (a, b, c) empfängt, eine Zwischenkreiseinheit (3) und eine Wechselrichtereinheit (4), wobei das Verfahren die folgenden Schritte umfasst:

- das Messen der Ströme (Ia, Ib, Ic) der dreiphasigen Stromversorgungsleitungen (a, b, c),
- das Messen der Spannung der Zwischenkreiseinheit (3) und das Einstellen der Anfangskapazität $C_{int}$ des Zwischenkreises, wobei die Anfangskapazität des Zwischenkreises vom Benutzer vorgegeben wird,
- das Bestimmen von Wechselrichterschaltzuständen des Wechselrichters und Gleichrichterschaltzuständen des Gleichrichters für jede Phase a, b, c, wobei die Schaltzustände einen Wert gleich 0 oder 1 aufweisen,
- das Erzeugen eines Triggersignals $S_{TRIG}$, wenn der Wert der Wechselrichterschaltzustände des Wechselrichters für jede Phase a, b, c einen Gleichwert aufweist, sowie das Bestimmen einer Triggerzeitdauer t für das erzeugte Triggersignal,
- das Bestimmen der Gleichrichterschaltzustände der Gleichrichtereinheit (2) für jede Phase a, b, c innerhalb der Auslösezeit t und das Messen der Ströme (Ia, Ib, Ic) der dreiphasigen Stromversorgungsleitungen a, b, c innerhalb der Auslösezeit sowie das Messen der Spannung des Zwischenkreises innerhalb der Auslösezeit t,
- das Rekonstruieren des Zwischenkreisstroms $I_{DC}(t)$ innerhalb der Auslösezeit t unter Verwendung der folgenden Formeln:

$$I_{DC}(t) = S_{aREC}(t) \cdot I_a(t) + S_{bREC}(t) \cdot I_b(t) + S_{cREC}(t) \cdot I_c(t)$$

- wo:
- $I_a(t)$ - ein gemessener Strom für Phase a innerhalb der Auslösezeit t ist,
- $I_b(t)$ - ein gemessener Strom für Phase b innerhalb der Auslösezeit t ist,
- $I_c(t)$ - ein gemessener Strom für Phase c innerhalb der Auslösezeit t ist,
- $S_{aREC}(t)$ - ein Wert des Schaltsignals des Gleichrichters für Phase a innerhalb der Auslösezeit t ist,

- $S_{bREC}(t)$ - ein Wert des Schaltsignals des Gleichrichters für Phase b innerhalb der Auslösezeit t ist,
- $S_{cREC}(t)$ - ein Wert des Schaltsignals des Gleichrichters für Phase c innerhalb der Auslösezeit t ist,

- das Berechnen eines ESR-Indikators (Equivalent Series Resistance, äquivalenter Serienwiderstand) für die Zwischenkreisspannung innerhalb der Auslösezeit t gemäß den Formeln:

$$ESR(t) = \int_{T_{on}}^{T_{off}} \frac{\dfrac{dU_{DC}(t)}{dt} - \dfrac{I_{DC}(t)}{C_{init}}}{\dfrac{dI_{DC}(t)}{dt}} dt$$

wo:

$U_{DC}(t)$ - eine gemessene Zwischenkreisspannung innerhalb der Auslösezeit t ist,
$C_{init}$ - die vom Benutzer angegebene und im Umrichtersteuergerät gespeicherte anfängliche Zwischenkreiskapazität ist,
$I_{DC}(t)$ - ein rekonstruierter Strom des Zwischenkreises innerhalb der Auslösezeit t ist,
$T_{on}$ - die Startzeit des getriggerten Signals $S_{TRIG}$ ist
$T_{off}$ - die Stoppzeit des getriggerten Signals $S_{TRIG}$ ist,

- das Berechnen einer gesamten Zwischenkreiskapazität C gemäß den Formeln:

$$C\,[\%] = \frac{(I_{DC}(t) \cdot ESR(t) - U_{DC}(t))^2}{U_{DC}^2(t)} \cdot 100\%$$

wo:

$I_{DC}(t)$ - der berechnete Zwischenkreisstrom innerhalb der Auslösezeit t ist,
$U_{DC}(t)$ - eine gemessene Zwischenkreisspannung innerhalb der Auslösezeit t ist,
$ESR(t)$ der berechnete äquivalente Serienwiderstandsindikator innerhalb der Auslösezeit t ist,
und

- das Vergleichen des Wertes der gesamten Zwischenkreiskapazität C mit der anfänglichen Zwischenkreiska-pazität $C_{int}$ durchgeführt wird und das Auslösen eines Alarms, wenn die gesamte Zwischenkreiskapazität C größer ist als die anfängliche Zwischenkreiskapazität $C_{int}$ multipliziert mit einem vom Benutzer vorgegebenen Schwellenwert.

2.  Das System zum Überwachen der Zwischenkreiskapazität in einem Leistungswandler, umfassend eine Leistungswandlerschaltung (1) mit einer Gleichrichtereinheit (2), die Leistung von dreiphasigen Stromversorgungsleitungen (a, b, c) empfängt, eine Zwischenkreiseinheit (3); eine Wechselrichtereinheit (4), die mit einer Umrichtersteuereinheit (5) und mit einer Gleichstromüberwachungseinheit (6) und mit Mitteln zum Messen elektrischer Parameter des Systems verbunden sind, ferner mit Mitteln zum Einstellen der Anfangskapazität $C_{int}$ des Zwischenkreises, wobei die Anfangskapazität des Zwischenkreises vom Benutzer in einer Computervorrichtung angegeben wird; Mittel zum Bestimmen von Wechselrichterschaltzuständen der Wechselrichtereinheit (4) für eine Phase; Mittel zum Vergleichen des Wertes von Wechselrichterschaltzuständen und zum Erzeugen eines Triggersignals $S_{TRIG}$; Mittel zum Bestimmen der Auslösezeit t; Mittel zum Rekonstruieren des Zwischenkreisstroms innerhalb der Auslösezeit t;
    **dadurch gekennzeichnet, dass es ferner umfasst:**

    - Mittel zum Bestimmen von Wechselrichterschaltzuständen der Wechselrichtereinheit (4) und Mittel zum Bestimmen von Gleichrichterschaltzuständen der Gleichrichtereinheit (2) für jede Phase a, b, c, die in der Computervorrichtung eingegeben sind,
- Mittel zum Vergleichen des Wertes von Wechselrichterschaltzuständen und zum Erzeugen eines Triggersignals $S_{trig}$, wenn der Wert der Wechselrichterschaltzustände der Wechselrichtereinheit (4) für jede Phase a, b, c gleiche Werte aufweist, die in der Wechselrichtersteuereinheit (5) implementiert sind, wobei die Mittel zum Bestimmen der Auslösezeit t eingegeben sind,
- Mittel zum Bestimmen der Gleichrichterschaltzustände der Gleichrichtereinheit (2) für jede Phase a, b, c innerhalb der Auslösezeit t und Mittel zum Messen der drei Phasenströme (Ia, Ib, Ic) von den drei Phasenstromleitungen (a, b, c) innerhalb der Auslösezeit t, und Mittel zum Messen der Spannung der Zwischenkreiseinheit (3) innerhalb der Auslösezeit t,
- Mittel zum Berechnen einer gesamten Zwischenkreiskapazität C und eines ERS-Indikators (Equivalent Series Resistance, äquivalenter Serienwiderstand) für die Zwischenkreisspannung (3) innerhalb der Auslösezeit Zeitdauer t und eines rekonstruierten Zwischenkreisstroms ($I_{DC}(t)$) innerhalb der Auslösezeit t, wobei die gesamte Zwischenkreiskapazität C nach den Formeln berechnet wird:

$$C \, [\%] = \frac{(I_{DC}(t) \cdot ESR(t) - U_{DC}(t))^2}{U_{DC}^2(t)} \cdot 100\%$$

wo:

$I_{DC}(t)$ - der Zwischenkreisstrom innerhalb der Auslösezeit t ist,
$U_{DC}(t)$ - eine gemessene Zwischenkreisspannung innerhalb der Auslösezeit t ist,
ESR(t) - ein Indikator ESR (Equivalent Series Resistance, äquivalenter Serienwiderstand) für die Zwischenkreisspannung ist, die innerhalb der Auslösezeit t berechnet wird, und der ESR-Indikator nach den Formeln berechnet wird:

$$ESR(t) = \int_{T_{on}}^{T_{off}} \frac{\dfrac{dU_{DC}(t)}{dt} - \dfrac{I_{DC}(t)}{C_{init}}}{\dfrac{dI_{DC}(t)}{dt}} dt$$

wo:

$U_{DC}(t)$ - eine gemessene Zwischenkreisspannung innerhalb der Auslösezeit t ist,
$C_{init}$ - die vom Benutzer angegebene und im Umrichtersteuergerät gespeicherte anfängliche Zwischenkreiskapazität ist,
$I_{DC}(t)$ - ein rekonstruierter Strom des Zwischenkreises innerhalb der Auslösezeit t ist,
$T_{on}$ - die Startzeit des getriggerten Signals $S_{TRIG}$ ist,
$T_{off}$ - die Stoppzeit des getriggerten Signals $S_{TRIG}$ ist, wobei der rekonstruierte Zwischenkreisstrom nach den formeln berechnet wird:

$$I_{DC}(t) = S_{aREC}(t) * I_a(t) + S_{bREC}(t) * I_b(t) + S_{cREC}(t) * I_c(t)$$

wo:

$I_a(t)$ ein gemessener Strom für Phase a innerhalb der Auslösezeit t ist,
$I_b(t)$ ein gemessener Strom für Phase b innerhalb der Auslösezeit t ist,

$I_c(t)$ ein gemessener Strom für Phase c innerhalb der Auslösezeit t ist,

$S_{aREC}(t)$ ein Wert des Schaltsignals des Gleichrichters für Phase a innerhalb der Auslösezeit t ist,

$S_{bREC}(t)$ ein Wert des Schaltsignals des Gleichrichters für Phase b innerhalb der Auslösezeit t ist,

$S_{cREC}(t)$ ein Wert des Schaltsignals des Gleichrichters für Phase c innerhalb der Auslösezeit t ist,

- Mittel zum Vergleichen des Wertes der gesamten Zwischenkreiskapazität C (3) mit der anfänglichen Zwischenkreiskapazität $C_{int}$,
- Mittels zum Auslösen eines Alarms, wenn die gesamte Zwischenkreiskapazität C größer ist als die anfängliche Zwischenkreiskapazität $C_{int}$ multipliziert mit einem vom Benutzer vorgegebenen Schwellenwert.

**3.** Das System nach Anspruch 2, **dadurch gekennzeichnet, dass** die Wandlerschaltung (1) feste Schalter (2a, 2b, 2c) und (3a, 3b, 3c) umfasst, die mit den Schaltelementen der Gleichrichtereinheit (2) bzw. der Wechselrichtereinheit 4 verbunden sind.

**4.** Das System nach Anspruch 3, **dadurch gekennzeichnet, dass** die festen Schalter (2a, 2b, 2c) und (3a, 3b, 3c) in Form von Dioden oder Transistoren bzw. Thyristoren vorhanden sind.

**5.** Das Computerprogramm zum Überwachen der Zwischenkreiskapazität in einem Stromrichtersystem, wobei das Computerprogramm in eine Datenverarbeitungseinheit (13) einer Computervorrichtung in Form einer Gleichstromüberwachungsvorrichtung (6) ladbar und ausführbar ist und das Computerprogramm Anweisungen umfasst, um das System nach Anspruch 2 zu veranlassen, die Schritte des Verfahrens nach Anspruch 1 auszuführen.

**Revendications**

**1.** Une méthode de surveillance de la capacité de liaison CC dans les convertisseurs de puissance, comprenant une unité de redressement (2) recevant de l'énergie à partir de lignes d'alimentation triphasées (a, b, c), une unité de liaison CC (3) et une unité d'onduleur (4), où ladite méthode comprend les étapes suivantes :

- mesure des courants (Ia, Ib, Ic) des lignes d'alimentation triphasées (a, b, c),
- mesure de la tension de l'unité de liaison CC (3) et réglage de la capacité initiale $C_{int}$ de la liaison CC, la capacité initiale de la liaison CC étant donnée par l'utilisateur,
- détermination des états de commutation de l'onduleur et des états de commutation du redresseur pour chaque phase a, b, c, où les états de commutation ont une valeur égale à 0 ou 1,
- génération d'un signal de déclenchement $S_{décl}$ lorsque la valeur des états de commutation l'onduleur pour chaque phase a, b, c a une valeur égale et détermination d'une durée de temps de déclenchement t pour le signal de déclenchement généré,
- détermination des états de commutation de l'unité de redressement (2) pour chaque phase a, b, c à la durée de temps de déclenchement t et mesure des courants (Ia, Ib, Ic) des lignes d'alimentation triphasées a, b, c au temps du déclenchement et mesure de la tension de la liaison CC à la durée de temps de déclenchement t,
- reconstitution du courant de liaison CC $I_{CC}(t)$ à la durée de temps de déclenchement t à l'aide des formules suivantes :

$$I_{CC}(t) = S_{aREC}(t) \cdot I_a(t) + S_{bREC}(t) \cdot I_b(t) + S_{cREC}(t) \cdot I_c(t)$$

- où :
- $I_a(t)$ - est un courant mesuré pour la phase a à la durée de temps de déclenchement t,
- $I_b(t)$ - est un courant mesuré pour la phase b à la durée de temps de déclenchement t,
- $I_c(t)$ - est un courant mesuré pour la phase c à la durée de temps de déclenchement t,
- $S_{aREC}(t)$ - est une valeur du signal de commutation de l'unité de redressement pour la phase a à la durée de temps de déclenchement t,
- $S_{bREC}(t)$ - est une valeur du signal de commutation de l'unité de redressement pour la phase b à la durée de temps de déclenchement t,
- $S_{cREC}(t)$ - est une valeur du signal de commutation de l'unité de redressement pour la phase c à la durée de temps de déclenchement t,

- calcul d'un indicateur RSE (résistance série équivalente) pour la tension de la liaison CC à la durée de temps de déclenchement t, selon les formules:

$$RSE(t) = \int_{T_{on}}^{T_{off}} \frac{\frac{dU_{cc}(t)}{dt} - \frac{I_{cc}(t)}{C_{init}}}{\frac{dI_{cc}(t)}{dt}} dt$$

où :

$U_{CC}(t)$ - est une tension de liaison CC mesurée à la durée de temps de déclenchement t,
$C_{init}$ - est la capacité initiale de la liaison CC donnée par l'utilisateur et stockée dans l'unité de commande de convertisseur,
$I_{CC}(t)$ - est un courant reconstitué de la liaison CC à la durée de temps de déclenchement t,
$T_{on}$ - est le temps de début du signal de déclenchement $S_{décl}$,
$T_{off}$ - est le temps d'arrêt du signal de déclenchement $S_{décl}$,

- calcul d'une capacité totale C de liaison CC selon les formules :

$$C\,[\%] = \frac{(I_{CC}(t) \cdot RSE(t) - U_{CC}(t))^2}{U_{CC}^2(t)} \cdot 100\%$$

où :

$I_{CC}(t)$ - est un courant calculé de la liaison CC à la durée de temps de déclenchement t,
$U_{CC}(t)$ - est une tension mesurée de la liaison CC à la durée de temps de déclenchement t,
$RSE(t)$ est l'indicateur de résistance série équivalente calculé à la durée de temps de déclenchement t, et

- comparaison de la valeur de la capacité totale C de la liaison CC avec la capacité initiale $C_{int}$ de la liaison CC est effectuée et déclenchement d'une alarme lorsque la capacité totale C de la liaison CC est supérieure à la capacité initiale $C_{int}$ de la liaison CC multipliée par une valeur de seuil donnée par l'utilisateur.

**2.** Un système de surveillance de la capacité de liaison CC dans un convertisseur de puissance comprenant un circuit de convertisseur de puissance (1) avec une unité de redressement (2) recevant de l'énergie à partir de lignes d'alimentation triphasées (a, b, c), une unité de liaison CC (3); une unité d'onduleur (4) qui sont connectés à une unité de commande de convertisseur (5) et à une unité de surveillance CC (6) et à des moyens pour mesurer les paramètres électriques du système, comportant en outre des moyens pour régler la capacité initiale $C_{int}$ de la liaison CC, où la capacité initiale de la liaison CC est donnée par l'utilisateur dans un dispositif informatique ; des moyens pour déterminer les états de commutation de l'unité d'onduleur (4) pour une phase ; des moyens pour comparer la valeur des états de commutation d'onduleur et pour générer un signal de déclenchement $S_{décl}$ ; des moyens pour déterminer une durée de temps de déclenchement t ; des moyens pour reconstituer le courant de liaison CC à la durée de temps de déclenchement t ;
**caractérisé en ce qu'il comprend en outre :**

- des moyens pour déterminer les états de commutation de l'unité d'onduleur (4) et des moyens pour déterminer les états de commutation de l'unité de redressement (2) pour chaque phase a, b, c, mis en œuvre dans le dispositif informatique,
- des moyens pour comparer la valeur des états de commutation d'onduleur et pour générer un signal de déclenchement $S_{décl}$ lorsque la valeur des états de commutation d'onduleur de l'unité d'onduleur (4) pour chaque phase a, b, c a des valeurs égales, mis en œuvre dans l'unité de commande de convertisseur (5), où des moyens pour déterminer la durée de temps de déclenchement t sont mis en oeuvre,
- des moyens pour déterminer les états de commutation de l'unité de redressement (2) pour chaque phase a, b, c à la durée de temps de déclenchement t et des moyens pour mesurer les courants triphasés (Ia, Ib, Ic) des lignes d'alimentation triphasées (a, b, c) à la durée de temps de déclenchement t,
et des moyens pour mesurer la tension de l'unité de liaison CC (3) à la durée de temps de déclenchement t,
- des moyens pour calculer une capacité totale C de la liaison CC et un indicateur RSE (résistance série équivalente) pour la tension de l'unité de liaison CC (3) à la durée de temps de déclenchement t, et un courant de liaison CC reconstitué ($I_{CC}(t)$) à la durée de temps de déclenchement t, où la capacité totale C de la liaison CC est calculée selon les formules :

$$C\ [\%] = \frac{(I_{CC}(t) \cdot RSE(t) - U_{CC}(t))^2}{U_{CC}^2(t)} \cdot 100\%$$

où :

$I_{CC}(t)$ - est un courant de liaison CC à la durée de temps de déclenchement t,
Ucc(t) - est une tension mesurée de liaison CC à la durée de temps de déclenchement t,
RSE(t) - est un indicateur RSE (résistance série équivalente) pour la tension de liaison CC calculée à la durée de temps de déclenchement t, et l'indicateur RSE est calculé selon les formules:

$$RSE(t) = \int_{T_{on}}^{T_{off}} \frac{\frac{dU_{CC}(t)}{dt} - \frac{I_{CC}(t)}{C_{init}}}{\frac{dI_{CC}(t)}{dt}}\, dt$$

où :

$U_{CC}(t)$ - est une tension de liaison CC mesurée à la durée de temps de déclenchement t,
$C_{init}$ - est la capacité initiale de liaison CC donnée par l'utilisateur et stockée dans l'unité de commande de convertisseur,
$I_{CC}(t)$ - est un courant reconstitué de liaison CC à la durée de temps de déclenchement t,
$T_{on}$ - est le temps de début du signal de déclenchement $S_{décl}$,
$T_{off}$ - est le temps d'arrêt du signal de déclenchement $S_{décl}$, où le courant de liaison CC reconstitué est calculé selon les formules :

$$I_{CC}(t) = S_{aREC}(t) * I_a(t) + S_{bREC}(t) * I_b(t) + S_{cREC}(t) * I_c(t)$$

où :

$I_a(t)$ est un courant mesuré pour la phase a à la durée de temps de déclenchement t,
$I_b(t)$ est un courant mesuré pour la phase b à la durée de temps de déclenchement t,
$I_c(t)$ est un courant mesuré pour la phase c à la durée de temps de déclenchement t,
$S_{aREc}(t)$ est une valeur du signal de commutation de l'unité de redressement pour la phase a à la durée de temps de déclenchement t,
$S_{bREC}(t)$ est une valeur du signal de commutation de l'unité de redressement pour la phase b à la durée de temps de déclenchement t,

$S_{cREC}$ (t) est une valeur du signal de commutation de l'unité de redressement pour la phase c à la durée de temps de déclenchement t,

- des moyens pour comparer la valeur de la capacité totale C de l'unité de liaison CC (3) à la capacité initiale $C_{int}$ de la liaison CC,
- des moyens pour déclencher une alarme lorsque la capacité totale C de la liaison CC est supérieure à la capacité initiale $C_{int}$ de la liaison CC multipliée par une valeur de seuil donnée par l'utilisateur.

3. Un système selon la revendication 2, **caractérisé en ce que** le circuit convertisseur 1 comprend des commutateurs solides (2a, 2b, 2c) et (3a, 3b, 3c) connectés aux branches de commutation de l'unité de redressement (2) et de l'unité d'onduleur 4, respectivement.

4. Un système selon la revendication 3, **caractérisé en ce que** les commutateurs solides (2a, 2b, 2c) et (3a, 3b, 3c) ont une forme de diodes ou de transistors, ou de thyristors.

5. Un programme informatique pour surveiller la capacité de liaison CC dans un système de convertisseur de puissance, ledit programme informatique pouvant être chargé et exécuté sur une unité de traitement de données (13) d'un dispositif informatique ayant une forme d'un dispositif de surveillance CC (6), et ledit programme informatique comprenant des instructions pour amener le système selon la revendication 2 à exécuter les étapes de la méthode selon la revendication 1.

**Fig. 1**

Fig.2

**Fig. 3**

**Fig. 4**

**Fig. 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100295554 A1
- US 6381158 B1
- US 20090072839 A
- EP 0652445 A
- US 20130155729 A